# EUROPÄISCHE PATENTSCHRIFT

(11) **EP 1 135 808 B1**
(45) Veröffentlichungstag und Bekanntmachung des Hinweises auf die Patenterteilung: **03.05.2006**
(21) Anmeldenummer: 99959223.1
(22) Anmeldetag: 22.10.1999
(51) Int. Cl.: H01L 29/06, H01L 29/167

(54) **LEISTUNGSHALBLEITER UND HERSTELLUNGSVERFAHREN**
POWER SEMICONDUCTOR AND A CORRESPONDING PRODUCTION METHOD
SEMI-CONDUCTEUR DE PUISSANCE ET PROCEDE DE FABRICATION ASSOCIE

(30) Priorität: 23.10.1998 DE 19848984
(43) Veröffentlichungstag der Anmeldung: 26.09.2001
(73) Patentinhaber: Infineon Technologies AG, 81669 München (DE)
(72) Erfinder: SCHULZE, Hans-Joachim, D-85521 Ottobrunn (DE)
(74) Vertreter: Bickel, Michael
(86) Internationale Anmeldenummer: PCT/DE1999/003395
(87) Internationale Veröffentlichungsnummer: WO 2000/025362

(56) Entgegenhaltungen:
- DE-A- 19 531 369
- US-A- 2 809 165
- US-A- 2 954 308
- US-A- 4 672 738

## Beschreibung

Die,vorliegende Erfindung betrifft einen Leistungshalbleiter gemäß Anspruch 1 sowie ein Verfahren zur Herstellung eines Leistungshalbleiters gemäß Anspruch 13.

Bei Leistungshalbleitern ist es erforderlich, die Bauelemente so zu bilden, daß sie den mit hohen Leistungen typisch einhergehenden Spannungen widerstehen können. Wenn durch das Leistungsbauelement kein Durchlaß-Strom fließt, fallen diese Spannungen vollständig über den Halbleiter ab und müssen dementsprechend gesperrt werden. Hierbei bauen sich zwischen unterschiedlich dotierten Bereichen sehr große Feldstärken auf, insbesondere an den Rändern des Halbleiters, wo sich die Randabschlüsse der sperrenden p-n-Übergänge befinden. Nur beispielsweise wird hinsichtlich der Bildung derartiger Randabschlüsse verwiesen auf die US-A-4.672.738.

Wenn ein Leistungshalbleiter sowohl in Vorwärts- als auch in Rückwärtsrichtung sperren soll, müssen jeweils entsprechende Randabschlüsse sowohl für den in Vorwärtsrichtung sperrenden p-n-Übergang als auch für den in Rückwärtsrichtung sperrenden Übergang vorgesehen werden. Bei sehr großflächigen Leistungshalbleitern kann dies durch eine mechanische Bearbeitung der Randbereiche realisiert werden. Dazu können die Bauelemente geläppt oder sandgestrahlt werden, um z.B. sog. positive oder negative Winkel zu erzeugen, die bei Sperrspannungsbelastung durch eine Aufweitung der Raumladungszone eine Absenkung der elektrischen Feldstärke im Randbereich bewirken.

Bei kleinen Bauelementen ist dieser mechanische Randabschluß nicht sinnvoll, weil diese Art der Bearbeitung gegenüber den anderen Herstellungskosten einen zu großen Aufwand bedeuten und zudem erforderlich machen würde, auf einen runden Leistungshalbleiter überzugehen. Zudem gibt es Leistungshalbleiter, bei denen vergleichsweise geringe Eindringtiefen an den p-n-Übergängen verwendet werden, beispielsweise IGBTs. Bei den dort verwendeten geringen Eindringtiefen wäre eine sehr feine mechanische Bearbeitung erforderlich. Auch dadurch wird die Verwendung mechanisch erzeugter Randabschlüsse bei diesen Bauelementen weitgehend ausgeschlossen.

Prinzipiell ist es möglich, auf beiden Seiten eines flächigen Leistungshalbleiters jeweilige Randabschlüsse vorzusehen. Allerdings ist dies im Regelfall unerwünscht, weil die Realisierung eines Randabschlusses auf der Anodenseite eine vergleichsweise aufwendige Passivierung und Kontaktierung erfordert. Eine weitere Möglichkeit ist, die Randabschlüsse nur auf einer Seite, der Oberseite des Bauelementes, vorzusehen und über einen Verbindungsbereich aus eindiffundiertem Material eine ohmsche Verbindung zur Unterseite herzustellen. Als Material wird dabei im Stand der Technik beispielsweise Bor oder das schneller diffundierende Aluminium eingesetzt. An den Stellen, an welchen das Aluminium in der Fertigung in den Halbleiter eingebracht wird, um einen oberseitigen Randabschluß mit der Halbleiterunterseite leitend zu verbinden, kann der fertiggestellte Halbleiter getrennt werden, beispielsweise durch Zersägen. Aus diesem Grund spricht man auch von einer sogenannten Trenndiffusion.

Nachteilig bei der Herstellung einer Trenndiffusion ist im Stand der Technik jedoch die hohe Belastung des Halbleitermaterials, die durch die erforderlichen Diffusionstemperaturen von um 1240°C und die langen Eintreibzeiten bedingt ist, während welcher das Halbleitersubstrat auf der Diffusionstemperatur gehalten werden muß. Eintreibzeiten von wenigstens 50 Stunden sind auch bei Waferdicken von nur 300 Mikrometern üblich. Ein weiteres, mit der Bildung einer Trenndiffusion durch Aluminium verbundenes Problem ist, daß dieses nicht durch Siliziumdioxid, SiO₂, maskierbar ist. Aus diesem Grund werden in der Regel in Halbleiterfertigungslinien für ICs prinzipiell keine Aluminiumdiffusionen vorgenommen, weil hier befürchtet wird, daß die fehlende Maskierbarkeit im späteren Betrieb der Fertigungslinie zu Kreuzkontaminationen führen kann, beispielsweise durch eine Verschlechterung eines Gate-Oxids.

Die Aufgabe der vorliegenden Erfindung besteht darin, Neues für die gewerbliche Anwendung bereitzustellen.

Die Lösung dieser Aufgabe wird unabhängig beansprucht. Bevorzugte Ausführungsformen finden sich in den abhängigen Ansprüchen.

Ein Grundgedanke der vorliegenden Erfindung besteht somit darin, die Bildung von Randabschlüssen ausschließlich auf einer Seite des Halbleitersubstrates dadurch zu vereinfachen, daß ein von oben nach unten durchgehender dotierter Bereich zur Schaffung einer ohmschen Verbindung vorgesehen wird, der mit Schwefel oder Selen dotiert ist. Es wurde erkannt, daß eine derartige Schwefel- oder Selendotierung, welche sich von einem Randabschluß auf der Oberseite zu einem Unterseiten-Halbleiterbereich erstreckt, beachtliche Vorteile gegenüber vorbekannten Dotierungen von Trenndiffusionsbereichen aufweist. Insbesondere Schwefel hat den Vorteil, daß die Diffusionsgeschwindigkeit in Silizium sehr hoch ist, was es ermöglicht, die Dotierung mit Schwefel durch Eindiffusion bei geringen Temperaturen und/oder kurzen Zeiten vorzunehmen. Dies verringert nicht nur die Materialbelastung, sondern erlaubt auch eine ökonomische Ausnutzung von Fertigungslinien und eine schnellere Herstellung eines Halbleiters insgesamt. Während auch Selen die für die Erfindung geeigneten n-dotierenden Eigenschaften aufweist, ist aus dem genannten Grund die Verwendung von Schwefel vorzuziehen

Die Erfindung ermöglicht es, sämtliche Randabschlüsse auf die Oberseite zu verlagern und dennoch den Leistungshalbleiter auf einfache und schnelle Weise herzustellen. Bevorzugt kann jeder Randabschluß durch eine Dotierung gebildet werden, beispielsweise als Dotierung mit lateraler Konzentrationsvariation wie in der vorzitierten US-A-4.672.738 beschrieben.

Der vorzugsweise schwefeldotierte oder auch selendotierte Bereich wird typischerweise an einem Rand beziehungsweise einer Kante des fertiggestellten Leistungshalbleiters vorgesehen, um von einem Randabschluß für die Rückwärtssperrfähigkeit eine Verbindung zur Unterseite zu schaffen. Es ist möglich, den schwefel- oder selendotierten Bereich so breit zu bilden, daß ein Halbleiterwafer bequem an dieser Stelle zersägt werden kann. Der schwefel- oder selendotierte Bereich liegt dann an einer Sägekante. Da der schwefel- oder selendotierte Bereich Donatoreigenschaften aufweist, also eine n-Leitfähigkeit besitzt, wird die niedrig dotierte Basiszone, welche zur Realisierung der angestrebten Sperrspannung erforderlich ist, entsprechend p-dotiert sein. Die zweite, höher dotierte Basiszone wird daher entsprechend n-dotiert sein. Weiter wird im Fall einer Thyristorstruktur der auf der Oberseite liegende Emitterbereich p-dotiert sein und der typisch auf der Unterseite liegende Emitterbereich n-dotiert.

Bei typischen Dicken und Grunddotierungen des Siliziumsubstrates ist es ausreichend, etwa 10¹⁴ bis 10¹⁶ Atome/cm² als Implantationsdosis in das Substrat einzudiffundieren. Die vor der Schwefelimplantation zu schützenden umliegenden Bereiche können mit Fotolack oder Siliziumdioxid auf einfache Weise maskiert werden. Die Maskierungsschichtdicke kann beispielsweise 1 Mikrometer betragen, was erfahrungsgemäß ausreicht.

Die einfache Maskierung erlaubt es, Schwefel oder Selen von beiden Substratseiten her in das Silizium einzutreiben. Auf diese Weise kann die Diffusionszeit gegenüber einer Eindiffusion nur von einer Seite her auf etwa ein Viertel verringert werden.

Schwefel- und selendotierte Randabschklüsse sind aus der DE-A-195 31 369 bekannt.

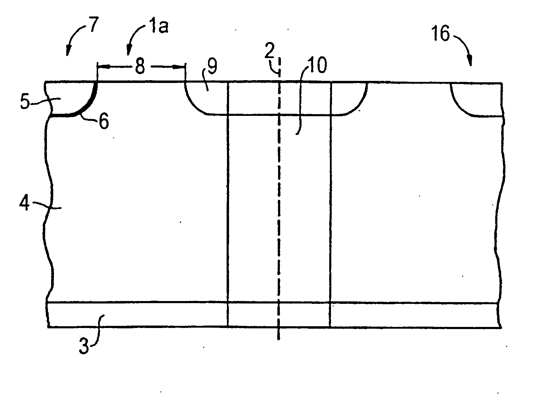

Die vorliegende Erfindung wird im folgenden nur beispielsweise anhand der Zeichnung beschrieben. In dieser zeigt die einzige
- Figur 1: einen Teil eines Querschnittes durch einen Siliziumwafer mit Strukturen für einen Leistungshalbleiter der vorliegenden Erfindung.

Fig. 1 zeigt einen Querschnitt durch einen Siliziumwafer an einem Ausschnitt, an welchem zwei später zu trennende Leistungshalbleiter bauelemente 1a und 1b mit ihren Randbereichen zusammen gebildet sind. Die beabsichtigte Trennlinie 2 ist gestrichelt eingezeichnet und die Randbereiche der Leistungshalbleitern bauelemente 1a und 1b sind zu der Trennlinie 2 spiegelsymmetrisch aufgebaut, so daß nachfolgend nur der Aufbau des Randbereiches links der Trennlinie 2 vom Leistungshalbleiter bauelement 1a zu beschreiben ist.

Der dargestellte Ausschnitt zeigt auch lediglich die Randbereiche des Leistungshalbleiter bauelementes, wo prinzipiell keine Kontakte, Gateanordnungen und dergleichen vorgesehen werden, wie sie bei Leistungsbauelementen erforderlich und bekannt sind, in welchen die zu beschreibenden Anordnung der vorliegenden Erfindung verwendet werden kann. Beispiele derartiger Leistungsbauelemente sind beispielsweise IGBTs, Thyristoren, abschaltbare Thyristoren (GTO) usw.

Nach Fig. 1 umfaßt der Randbereich eines beidseitig sperrenden Leistungshalbleiter bauelementes 1a einen n-dotierten unterseitigen Emitterbereich 3, eine niedrig p-dotierte Basiszone 4, eine zweite Basiszone 5 mit höherer n-Dotierung und einen Randabschluß 6 zur Oberfläche 7 des Leistungshalbleiters 1a hin, welcher für die Vorwärtssperrfähigkeit des Leistungshalbleiter bauelementes 1a gebildet ist. Um einen etwa der Substratdicke des Halbleitersubstrates entsprechenden Abstand 8 beabstandet vom Randabschluß 6 angeordnet ist ein n-dotierter Randabschluß 9 für die Rückwärtssperrfähigkeit vorgesehen.

Erfindungsgemäß führt nun von dem auf der Unterseite vorgesehenen n-dotierten Emitterbereich 3 eine schwefel- oder selendotierte Trenndiffusionszone 10 durch das Halbleitersubstrat zum Randabschluß 9 und stellt hierbei durch die Donatoreigenschaften des in die Siliziumscheiben eingebrachten Schwefels bzw. Selens eine ohmsche Verbindung zwischen dem Randabschluß für die Rückwärtssperrfähigkeit 9 und dem n-dotierten Unterseitenbereich 3 her.

Das beschriebene Halbleiter bauelement kann z.B. hergestellt werden wie folgt:

In der Herstellung werden zunächst die erforderlichen Halbleiterstrukturen wie Gateanschlüsse, Emitter, Kollektoren usw. in dem Siliziumwafer vorgesehen. Zugleich werden die Randabschlüsse 6 und 9 in bekannter Weise, beispielsweise durch Feldringe, Feldplatten und/oder, wie gezeigt, durch eine VLD-Struktur in per se bekannter Weise auf der Oberfläche des Leistungshalbleiters realisiert.

Dann wird eine Maskierung auf das Substrat an jenen Stellen aufgebracht, an welchen die Trenndiffusion geschaffen werden soll. Die Breite der von der Maskierung freigelassenen Bereiche ist ausreichend, um die Bauelemente 1a und 1b in der Mitte dieses Bereiches längs der Linie 2 später gut trennen zu können und dennoch an dem verbleibenden Rand eine Breite quer zur Verbindungslinie von etwa drei bis vier Eindringtiefen der Raumladungszone in die schwefel- oder selendotierte Zone 10 vorzusehen. Typisch wird daher hierfür eine Breite von ca. 100 bis 200 µm gewählt.

Dann wird eine Menge von etwa 10¹⁴ bis 10¹⁶ Dotierstoffatomen pro Quadratzentimeter auf beiden Seiten des Siliziumwafers implantiert und die Maskierung abgelöst.

Nachfolgend wird der Wafer auf eine Temperatur von 1200°C so lange erhitzt, bis die von beiden Seiten in das Silizium eindiffundierenden Dotierstofffronten ineinander gelaufen sind.

Nach dem Abkühlen kann der Wafer längs der Linie 2 zersägt werden und das Bauelement in gewohnter Weise kontaktiert werden.

Bei Leitungshalbleitern mit geringen Eindringtiefen der pn-Übergänge der höher dotierten Basiszone und der Emitter empfiehlt es sich dagegen, zuerst die Trenndiffusion mittels Dotierstoffatomen vorzusehen und erst dann die Emitter und die höher dotierte Basiszone zu erzeugen. In einigen Fällen kann es auch sinnvoll sein, die maskierte Implantation so in den Herstellungsprozeß des Leistungshalbleiters zu integrieren, daß ein Teil der zur Herstellung der Basis- und Emitterstrukturen erforderlichen Hochtemperaturprozesse zur Eindiffusion der Dotierstoffatome mitverwendet werden.

## Patentansprüche

1. Leistungshalbleiter bauelement mit auf einer von ober- (7) und Unterseite eines Siliziumsubstrats angeordneter Anode und auf der anderen von Ober- und Unterseite angeordneter Kathode , auf der Unterseite vorgesehenen, n-dotiertein Halbteiterberrich (3) und auf der Oberseite vorgesehenen, n-dotierten Randabschlüssen (6, 9) bei dem sich wenigstens ein n-dotierten Bereich (10) von einem Randabschluß (9) auf der Oberseite zum Halbleiterbereich (3) auf der Unterseite erstreckt, welcher durchgehend schwefeldotiert oder selendotiert ist.

2. Leistungshalbleiter bauelement nach Anspruch 1, bei dem nur auf der Oberseite (7) Randabschlüsse vorgesehen sind.

3. Leistungshalbleiter bauelement nach einem der vorhergehenden Ansprüche, bei dem wenigstens ein und vorzugsweise jeder Randabschluß (6, 9) durch Dotierung mit einer Konzentrationsvariation parallel zur Oberseite (7) gebildet ist.

4. Leistungshalbleiter bauelement nach einem der vorhergehenden Ansprüche, bei dem der schwefel- oder selendotierte Bereich (10) sich zu dem für die Erzielung der Rückwärtssperrfähigkeit bestimmten Randabschluß (9) erstreckt.

5. Leistungshalbleiter bauelement nach einem der vorhergehenden Ansprüche, bei dem der schwefel- oder selendotierte Bereich an einer Kante des Siliziumsubstrats angeordnet ist.

6. Leistungshalbleiter bauelement nach dem vorhergehenden Anspruch, bei dem der Schwefel- oder selendotierte Bereich an einer Sägekante des Siliziumsubstrats angeordnet ist.

7. Leistungshalbleiter bauelement nach einem der vorhergehenden Ansprüche, worin der schwefel- oder selendotierte Bereich (10) sich in parallel richtung zur oberseite (7) um wenigstens das zweifache, vorzugsweise zumindest das dreifache, insbesondere bevorzugt wenigstens das vierfache der Eindringtiefe Raumladungszone in den schwefel- oder selendotierte, (10) erstreckt.

8. Leistungshalbleiter bauelement nach einem der vorhergehenden Ansprüche, bei dem der schwefel- oder selendotierte Bereich (10) so hoch dotiert ist, daß eine ohmsche Verbindung mit im Vergleich zur Umgebung merklichen Leitfähigkeit zwischen dem Randabschluß und dem auf der Unterseite vorgesehenen Halbleiterbereich (5) geschaffen ist.

9. Leistungshalbleiter bauelement nach einem der vorhergehenden Ansprüche, bei dem der schwefel- oder selendotierte Bereich (10) durch Eindiffundieren einer zwischen 10¹⁴ bis 10¹⁶ Dotierstoffatomen pro Quadratzentimeter liegenden Implantationsdosis gebildet ist.

10. Leistungshalbleiter bauelement nach einem der vorhergehenden Ansprüche, bei dem **dadurch gekennzeichnet, daß** dieser eine niedrig p-dotierte Basiszone (4) aufweist.

11. Leistungshalbleiter bauelement nach einem der vorhergehenden Ansprüche, worin weiter eine höher dotierte Basiszone (5) vorgesehen ist und diese Basiszone (5) n-dotiert ist.

12. Leistungshalbleiter nach dem vorhergehenden Anspruch mit einem Emitterbereich, der p-dotiert ist und bei dem der auf Unterseite vorgesehene, n-dotierte Halbhiterbereich (3) ein Emitterbereich ist.

13. Verfahren zur Herstellung eines Leistungshalbleiter bauelementes, insbesondere eines Leistungshalbleiters nach einem der vorhergehenden Ansprüche, worin an einer von Ober- und Unterseite eines flächigen Siliziumsubstrates ein Anode und an der anderen ein Kathode vorgesehen wird, n-dotierte Randabschlüsse (6, 9) für beide Sperrichtungen nur an der Oberseite vorgesehen werden und ein n-dotierter Halblerterbereich (3) an der Unterseite mit einem Randabschluß (10) auf der Oberseite verbunden wird, **dadurch gekennzeichnet, daß** die Verbindung durch einen n-dotierten Bereich (10) realisiert wird, der durch Eindiffusion von Schwefelatomen oder Selenatomen in das SiliziUmsubstrat gebildet wird.

14. Verfahren nach dem vorhergehenden Anspruch, worin eine Implantationsdosis von 10¹⁴ bis 10¹⁶ Atomen in das Material eindiffundiert wird, um den n-dotierten Bereich (10) zu realisierren.

15. Verfahren nach einem der vorhergehenden Verfahrensansprüchen, worin von beiden Substratseiten her Schwefel oder Selen in das Substrat eindiffundiert wird.

16. Verfahren nach einem der vorhergehenden Verfahrensansprüchen, worin der Dotierstoff bei einer Temperatur unterhalb 1240°C, bevorzugt unterhalb 1200°C und/oder während einer Zeit kürzer als 50 Stunden eindiffundiert wird.

17. Verfahren nach einem der vorhergehenden Verfahrensansprüche, worin die oder jede substratseite, auf welche Schwefel oder Selen implantiert wird, mit einer Maskierungsschicht maskiert wird.

18. Verfahren nach dem vorhergehenden Anspruch, worin die Maskierungsschicht aus Siliziumdioxid oder Fotolack gebildet ist.

19. Verfahren nach dem vorhergehenden Anspruch, worin die Maskierungsschicht vor der Eindiffusion abgelöst werden.

## Claims

1. Power semiconductor component having an anode arranged on one of the top side (7) and underside of a silicon substrate and a cathode arranged on the other of the top side and underside, an n-doped semiconductor region (3) provided on the underside, and n-doped edge terminations (6, 9) provided on the top side, in which at least one n-doped region (10) extends from an edge termination (9) on the top side to the semiconductor region (3) on the underside which is continuously sulphur-doped or selenium-doped.

2. Power semiconductor according to Claim 1, in which edge terminations are provided only on the top side (7).

3. Power semiconductor according to one of the preceding claims, in which at least one and preferably every edge termination (6, 9) is formed by doping with a concentration variation parallel to the top side (7).

4. Power semiconductor according to one of the preceding claims, in which the sulphur- or selenium-doped region (10) extends to the edge termination (9) intended for obtaining the reverse blocking capability.

5. Power semiconductor according to one of the preceding claims, in which the sulphur- or selenium-doped region is arranged at an edge of the silicon substrate.

6. Power semiconductor according to the preceding claim, in which the sulphur- or selenium-doped region is arranged at a sawing edge of the silicon substrate.

7. Power semiconductor according to one of the preceding claims, wherein the sulphur- or selenium-doped region (10) extends in the parallel direction to the top side (7) by at least twice, preferably at least three times, particularly preferably at least four times, the penetration depth of the space charge zone into the sulphur- or selenium-doped region (10).

8. Power semiconductor according to one of the preceding claims, in which the sulphur- or selenium-doped region (10) is doped so highly that an ohmic connection is produced with, in comparison with the surroundings, an appreciable conductivity between the edge termination and the semiconductor region (3) provided on the underside.

9. Power semiconductor according to one of the preceding claims, in which the sulphur- or selenium-doped region (10) is formed by indiffusion of an implantation dose of between 10¹⁴ and 10¹⁶ dopant atoms per square centimetre.

10. Power semiconductor according to one of the preceding claims, in which it has a lightly p-doped base zone (4).

11. Power semiconductor according to one of the preceding claims, wherein a more highly doped base zone (5) is further provided and this base zone (5) is n-doped.

12. Power semiconductor according to the preceding claim having an emitter region, which is p-doped, and n-doped semiconductor region (3) provided on the underside is an emitter region.

13. Method for fabricating a power semiconductor component, in particular a power semiconductor according to one of the preceding claims, wherein an anode is provided on one of the top side and underside of a planar silicon substrate and a cathode is provided on the other thereof, n-doped edge terminations (6, 9) for both blocking directions are provided only on the top side, and an n-doped semiconductor region (3) on the underside is connected to an edge termination (10) on the top side,
**characterized in that** the connection is realized by an n-doped region (10) which is formed by indiffusion of sulphur atoms or selenium atoms into the silicon substrate.

14. Method according to the preceding claim, wherein an implantation dose of 10¹⁴ to 10¹⁶ atoms is indiffused into the material in order to realize the n-doped region (10)

15. Method according to one of the preceding method claims, wherein sulphur or selenium is indiffused into the substrate from both substrate sides.

16. Method according to one of the preceding method claims, wherein the dopant is indiffused at a temperature below 1240°C, preferably below 1200°C, and/or during a time shorter than 50 hours.

17. Method according to one of the preceding method claims, wherein the or each substrate side on which sulphur or selenium is implanted is masked by a masking layer.

18. Method according to the preceding claim, wherein the masking layer is formed from silicon dioxide or photoresist.

19. Method according to the preceding claim, wherein the masking layer is stripped off before the indiffusion.

## Revendications

1. Composant semi-conducteur de puissance avec une anode disposée sur une des faces supérieure (7) et inférieure d'un substrat de silicium et une cathode disposée sur l'autre des faces supérieure et inférieure, une zone semi-conductrice dopée n (3) prévue sur la face inférieure, et des bordures dopées n (6, 9) prévues sur la face supérieure, au moins une zone dopée n (10) de manière traversante, au soufre ou au sélénium s'étendant d'une bordure (9) sur la face supérieure à une zone semi-conductrice (3) sur la face inférieure.

2. Composant semi-conducteur de puissance selon la revendication 1,
dans lequel
des bordures sont prévues uniquement sur la face supérieure (7).

3. Composant semi-conducteur de puissance selon l'une des revendications précédentes,
dans lequel
au moins une et de préférence chacune des bordures (6, 9) est formée par dopage avec une variation de concentration parallèle à la face supérieure (7).

4. Composant semi-conducteur de puissance selon l'une des revendications précédentes,
dans lequel
la zone dopée au soufre ou au sélénium (10) s'étend jusqu'à la bordure (9) déterminée pour la capacité de blocage en sens inverse.

5. Composant semi-conducteur de puissance selon l'une des revendications précédentes,
dans lequel
la zone dopée au soufre ou au sélénium est disposée sur une arête du substrat de silicium.

6. Composant semi-conducteur de puissance selon l'une des revendications précédentes,
dans lequel
la zone dopée au soufre ou au sélénium est disposée sur une arête de sciage du substrat de silicium.

7. Composant semi-conducteur de puissance selon l'une des revendications précédentes,
dans lequel
la zone dopée au soufre ou au sélénium (10) s'étend parallèlement à la face supérieure (7), sur au moins le double, de préférence au moins le triple, de manière particulièrement préférée au moins le quadruple de la profondeur d'atténuation de la zone de charge d'espace, dans la zone dopée au soufre ou au sélénium (10).

8. Composant semi-conducteur de puissance selon l'une des revendications précédentes,
dans lequel
la zone dopée au soufre ou au sélénium (10) est si fortement dopée qu'une liaison ohmique munie d'une conductibilité remarquable par rapport à l'environnement est créée entre la bordure et la zone semi-conductrice (3) prévue sur la face inférieure.

9. Composant semi-conducteur de puissance selon l'une des revendications précédentes,
dans lequel
la zone dopée au soufre ou au sélénium (10) est formée par diffusion intérieure d'une dose d'implantation de 10¹⁴ à 10¹⁶ atomes de dopant par centimètre carré.

10. Composant semi-conducteur de puissance selon l'une des revendications précédentes, qui présente une zone de base (4) faiblement dopée p.

11. Composant semi-conducteur de puissance selon l'une des revendications précédentes,
dans lequel
une zone de base (5) plus fortement dopée est prévue et cette zone de base (5) est dopée p.

12. Composant semi-conducteur de puissance selon l'une des revendications précédentes, avec une zone d'émission dopée p, et la zone semi-conductrice (3) dopée n prévue sur la face inférieure étant une zone d'émission.

13. Procédé pour fabriquer un composant semi-conducteur de puissance, en particulier un semi-conducteur de puissance selon une des revendications précédentes,
dans lequel
une anode est prévue sur une des faces supérieure et inférieure d'un substrat de silicium plat et une cathode sur l'autre,
des bordures dopées n (6, 9) pour les deux sens de blocage sont prévues uniquement sur la face supérieure, et
une zone semi-conductrice dopée n (3) sur la face inférieure est reliée à une bordure (10) sur la face supérieure,
**caractérisé en ce que**
la liaison est réalisée par une zone dopée n (10) formée par diffusion intérieure d'atomes de soufre ou d'atomes de sélénium dans le substrat de silicium.

14. Procédé selon la revendication précédente,
dans lequel
une dose d'implantation de 10¹⁴ à 10¹⁶ atomes est diffusée dans le matériau pour réaliser la zone dopée n (10).

15. Procédé selon la revendication précédente,
dans lequel
du soufre ou du sélénium est diffusé dans le substrat à partir des deux faces du substrat.

16. Procédé selon la revendication précédente,
dans lequel le dopant est diffusé à une température inférieure à 1240°C, de préférence inférieure à 1200°C et/ou pendant une durée de moins de 50 heures.

17. Procédé selon la revendication précédente,
dans lequel
la face ou chacune des faces du substrat sur lesquelles du soufre ou du sélénium est implanté est masquée par une couche de masquage.

18. Procédé selon la revendication précédente,
dans lequel
la couche de masquage est faite de dioxyde de silicium ou de laque photosensible.

19. Procédé selon la revendication précédente,
dans lequel
la couche de masquage est détachée avant la diffusion intérieure.
